# FASCICULE DE BREVET EUROPEEN

(11) **EP 0 609 158 B1**
(45) Date de publication et mention de la délivrance du brevet: **11.12.1996**
(21) Numéro de dépôt: 94420014.6
(22) Date de dépôt: 17.01.1994
(51) Int. Cl.: H03K 17/18, H03K 17/10, G01R 31/00

(54) **Interface de puissance de sécurité**
Sicherheitsleistungsschnittstelle
Fail-safe power interface

(30) Priorité: 29.01.1993 FR 9301077
(43) Date de publication de la demande: 03.08.1994
(73) Titulaire: SCHNEIDER ELECTRIC SA, 92100 Boulogne Billancourt (FR)
(72) Inventeur: Prunier, Michel, F-38050 Grenoble Cédex 09 (FR); Noraz, Serge, F-38050 Grenoble Cédex 09 (FR)
(74) Mandataire: Jouvray, Marie-Andrée

(56) Documents cités:
- EP-A- 0 204 624
- DE-A- 3 924 988
- US-A- 4 365 164
- US-A- 4 932 246
- US-A- 4 961 051

## Description

L'invention concerne une interface de puissance de sécurité.

Une telle interface de puissance est destinée à être interposée entre une interface de sécurité, et au moins un actionneur à contrôler. Il est en effet indispensable d'adapter la sortie de l'interface de sécurité, constituée de signaux logiques binaires, à la puissance requise par les actionneurs. L'invention est plus particulièrement destinée à être connectée à la sortie d'une interface de sécurité ou d'un module de vote décrit dans la demande de brevet européen EP-526.350. L'interface de sécurité précitée comporte un oscillateur de type multivibrateur astable en anneau, comportant un nombre impair d'éléments inverseurs, dont les entrées d'alimentation constituent les entrées fonctionnelles de l'interface, elles-mêmes connectées à la sortie d'automates. Dès que l'une des entrées n'est pas alimentée correctement, le signal de sortie de l'oscillateur est un signal continu. En cas de panne interne à l'interface, la sortie n'est pas modifiée ou mise dans un état sûr, correspondant à la non-oscillation de l'oscillateur. L'interface de sécurité comporte un circuit assurant le redressement des signaux de sortie de l'oscillateur. On obtient ainsi en sortie de l'interface de sécurité ou d'un module de vote constitué par des interfaces de sécurité de ce type, des signaux basse puissance, pouvant prendre deux niveaux logiques continus, dont l'un est considéré comme un état sûr. L'interface de sécurité a la propriété d'être à haute sécurité de fonctionnement vis à vis de l'ensemble des pannes qui peuvent se produite en son sein.

L'utilisation du codage dynamique d'un signal logique binaire continu pour la commande d'un transistor est connue du document EP-A-204 624. Par ailleurs, le document DE-A-3 924 988 décrit un dispositif de commande d'un relais, dans lequel la commande du relais est temporisée pour permettre la détection d'un défaut de deux transistors connectés en série avec la bobine du relais et un commutateur de commande.

L'invention a pour but une interface de puissance qui permette la commande d'un actionneur sans dégrader les performances de sécurité et/ou de disponibilité de l'interface de sécurité ou du module de vote disposés en amont.

Selon l'invention, l'interface de puissance de sécurité comportant une entrée, destinée à recevoir des signaux d'entrée logiques binaires continus, des moyens de codage dynamique des signaux continus d'entrée, des moyens de commande d'un commutateur de puissance, les moyens de commande étant connectés à une sortie des moyens de codage dynamique, et des moyens de surveillance de l'état du commutateur, est caractérisée en ce que le commutateur comporte au moins deux transistors de puissance connectés en série avec un actionneur entre les bornes d'une tension d'alimentation, chaque transistor comportant une électrode de commande connectée à une sortie correspondante des moyens de commande, l'interface comportant des moyens d'autotest de l'interface, connectés aux moyens de surveillance et comportant des moyens de production de signaux de test appliqués par les moyens de commande aux électrodes de commande des transistors, de manière à constituer une interface de puissance de sécurité.

Selon un développement de l'invention, les moyens d'autotest comportent des moyens de production de signaux d'horloge, connectés à une entrée de test des moyens de commande, et des moyens de détection pour détecter la tension aux bornes de chacun des transistors et fournir aux moyens de commande des signaux représentatifs desdites tensions, de manière à permettre un test en ligne des transistors de puissance.

Selon un développement de l'invention les moyens de codage dynamique comportent un oscillateur fournissant des signaux de fréquence prédéterminée lorsque le signal d'entrée prend une première valeur continue prédéterminée et des signaux continus lorsque le signal d'entrée prend une seconde valeur continue prédéterminée. La seconde valeur prédéterminée du signal d'entrée est, de préférence, associée à un état sûr de l'actionneur.

Selon un développement de l'invention, les moyens de commande comportent un circuit logique programmable fournissant sur deux sorties de commande distinctes, respectivement associées à chacun des transistors, des signaux oscillants lorsque les signaux de sortie des moyens de codage sont des signaux oscillants. De plus, les moyens de commande comportent des moyens de mise en forme connectés entre le circuit logique programmable et les transistors, de manière à appliquer sur les électrodes de commande des transistors un signal de commande de saturation lorsque le signal de sortie associé du circuit logique programmable est un signal oscillant, et un signal de commande de blocage lorsque ledit signal de sortie est un signal continu.

Le circuit logique programmable comporte, de préférence, une sortie de diagnostic produisant un signal oscillant en l'absence de défaillance interne à l'interface et un signal continu en cas de défaillance.

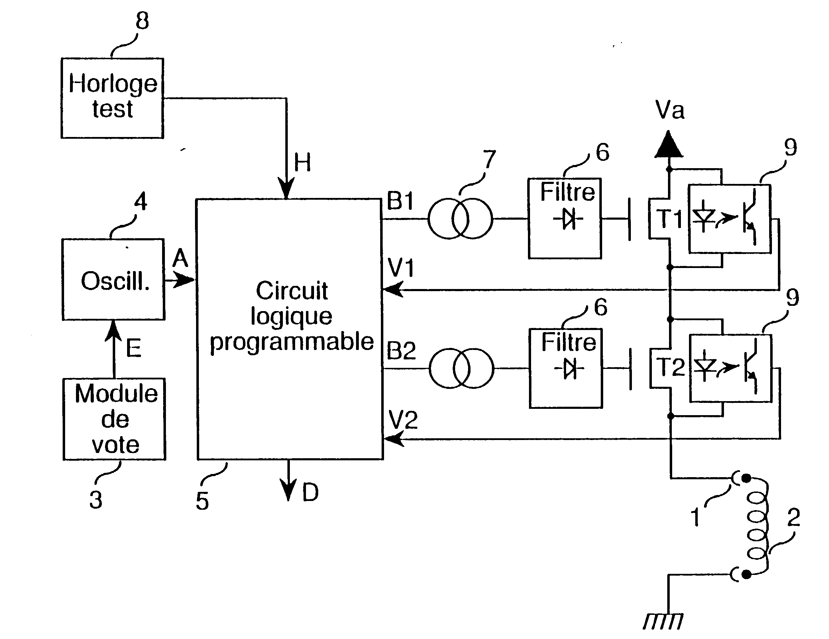

D'autres avantages et caractéristiques ressortiront plus clairement de la description qui va suivre, d'un mode particulier de réalisation de l'invention, donné à titre d'exemple non limitatif et représenté sur la figure unique annexée.

L'interface de puissance représentée sur la figure comporte deux transistors de puissance T1 et T2, par exemple de type MOS, connectés en série entre une tension d'alimentation Va et une sortie 1. Un actionneur 2 est destiné à être connecté entre la sortie 1 et la masse. Lorsque les deux transistors T1 et T2 sont saturés, la tension d'alimentation Va est appliquée aux bornes de l'actionneur 2. Si au moins l'un des transistors est bloqué, aucune tension n'est alors appliquée aux bornes de l'actionneur 2.

En fonctionnement normal, la sortie d'une interface de sécurité ou d'un module de vote 3, par exemple du type décrit dans la demande de brevet européen précitée, est connectée à une entrée de l'interface de puissance sur laquelle elle applique des signaux d'entrée E logiques, binaires, continus, basse puissance. Les signaux d'entrée E sont appliqués à l'entrée d'un oscillateur 4 qui réalise un codage dynamique des signaux d'entrée E. Si le signal d'entrée E est à un premier niveau logique prédéterminé, par exemple au niveau 1, l'oscillateur 4 délivre un signal A oscillant de fréquence prédéterminée, par exemple 500KHz. Par contre, si le signal d'entrée E est à un second niveau logique prédéterminé, par exemple au niveau 0, l'oscillateur 4 est inhibé et fournit un signal A continu en sortie.

La sortie de l'oscillateur 4 est connectée à l'entrée d'un circuit logique programmable 5, qui fournit des signaux de contrôle distincts, respectivement B1 et B2, aux transistors T1 et T2. En fonctionnement normal, lorsque E = 1, le circuit 5 transmet à ses sorties le signal A oscillant. Les signaux B1, B2, oscillants sont respectivement appliqués sur les électrodes de contrôle des transistors T1 et T2, par l'intermédiaire d'un circuit de filtrage et de redressement 6 associé. Un circuit 7 d'isolement galvanique, par exemple un transformateur, est intercalé entre chaque circuit 6 et la sortie correspondante du circuit 5. Des signaux oscillants, B1 et B2, commandent ainsi la saturation des transistors T1 et T2 et l'application de la tension d'alimentation Va aux bornes de l'actionneur 2. Par contre, si le signal d'entrée E est nul, le signal A de sortie de l'oscillateur 4 est un signal continu et le circuit logique programmable 5 fournit des signaux B1 et B2 continus. Les signaux appliqués sur les électrodes de commande des transistors T1 et T2 sont alors des signaux de blocage et aucune tension n'est appliquée aux bornes de l'actionneur 2.

Toute défaillance interne du circuit logique programmable 5 se traduit par le blocage à un niveau continu de tension de ses entrées et/ou de ses sorties. Les signaux B1 et B2 ne peuvent donc être tous deux oscillants et au moins un des transistors est bloqué, de sorte qu'aucune tension n'est appliquée à l'actionneur 2. Il en va de même en cas de panne intrinsèque à l'oscillateur 4 entraînant une perte d'oscillation. Pour assurer la sécurité, l'actionneur 2 est tel qu'il soit dans un état dit sûr lorsqu'aucune tension ne lui est appliquée. Pour assurer la sécurité de l'installation, le signal d'entrée E de l'interface de puissance est à son niveau bas lorsqu'une défaillance a été détectée en amont, dans l'interface de sécurité ou le module de vote 3, conduisant ainsi au blocage des transistors T1 et T2 et au passage de l'actionneur 2 dans un état sûr.

Certaines défaillances internes de l'interface de puissance conduisent également automatiquement l'actionneur à prendre un état sûr. C'est le cas notamment du collage d'un des transistors à l'état bloqué, de l'ouverture d'un des conducteurs de l'interface, de l'ouverture du circuit de découplage galvanique 7 ou du circuit 6.

Certaines défaillances ne conduisent pas automatiquement au passage de l'actionneur dans un état sûr. C'est le cas, en particulier, du collage d'un des transistors à l'état saturé. Une telle défaillance doit être considérée comme dangereuse et il est indispensable de la détecter. L'interface de puissance est, dans ce but, complétée par des moyens de détection d'une défaillance des transistors de puissance.

Cette détection s'effectue au moyen d'un test cyclique en ligne des transistors de puissance. Le test est réalisé sous le contrôle d'une horloge de test 8 qui applique des signaux H d'horloge sur une entrée de test du circuit logique programmable 5, les signaux H servant de base de temps pour séquencer l'exécution d'un auto-test. Un tel auto-test est, par exemple, effectué toutes les 20ms.

Pour vérifier l'état d'un transistor, T1 ou T2, un circuit de détection de tension 9 est connecté en parallèle sur ce transistor et sa sortie est connectée à une entrée du circuit 5. Le circuit de détection de tension 9 est, de préférence, constitué par un opto-coupleur. Le signal, V1 ou V2, de sortie du circuit de détection de tension 9 est représentatif de l'état du transistor correspondant, dont la tension aux bornes est sensiblement nulle lorsqu'il est saturé.

Lorsque E = 1, les signaux A, B1 et B2 sont des signaux oscillants et les transistors T1 et T2 sont saturés. L'application d'un signal H au circuit 5 provoque l'interruption brève du signal de commande de l'un des transistors, T1 par exemple, et la vérification, par l'intermédiaire du circuit 9 associé, de son passage à l'état de blocage. Ce transistor est de nouveau saturé et la même opération est effectuée sur le second transistor, T2. Ce test est du type à impulsions fines, c'est à dire que la durée du blocage est suffisamment longue pour en permettre la détection, mais trop courte pour être prise en compte par l'actionneur.

Un test permettant de vérifier que les transistors ne sont pas collés en position de blocage est effectué lorsque E = 0. Dans ce cas, les signaux A, B1 et B2 sont continus et les transistors T1 et T2 bloqués. L'application d'un signal H au circuit 5 provoque successivement l'application d'un signal de commande sur chacun des transistors permettant de vérifier qu'il passe effectivement à l'état saturé. Il est à noter que, lorsque les transistors sont bloqués, leur polarisation s'effectue par l'intermédiaire des circuits de détection 9.

Lors du déroulement de l'auto-test, les signaux V1 et V2 appliqués au circuit 5 sont analysés par celui-ci. Une défaillance de l'un des transistors est ainsi détectée et deux modes de fonctionnement peuvent être prévus pour le circuit 5 en cas de défaillance détectée.

Selon un premier mode de fonctionnement, favorisant la sécurité, le circuit 5 bloque ses sorties B1 et B2 à un niveau continu de tension, bloquant les deux transistors T1 et T2 ou, si l'un d'eux est collé en position saturée, bloquant l'autre, de manière à faire passer l'actionneur en position sûr. Simultanément, la défaillance est signalée sur une sortie de diagnostic du circuit 5. En l'absence de défaillance, le circuit 5 fournit sur cette sortie un signal D oscillant. Lorsqu'une défaillance est détectée, le signal D devient un signal continu.

Selon un second mode de fonctionnement, favorisant la disponibilité, le circuit 5 maintient les commandes des transistors en l'état, même après détection d'une panne. Cette panne est, comme précédemment, signalée sur la sortie de diagnostic par un signal D continu. Pour améliorer la sécurité du système il peut être avantageux de distinguer les deux modes de fonctionnement. A titre d'exemple non limitatif, un niveau continu haut du signal D peut correspondre au premier mode de fonctionnement, tandis qu'un niveau continu bas du signal D correspond au second mode de fonctionnement. Un système de surveillance, non représenté, recevant les signaux D est alors conçu de manière à signaler différemment ces deux modes de fonctionnement à un opérateur, qui peut alors plus facilement déterminer le degré d'urgence d'une intervention.

Le signal D passe aussi à un niveau continu en cas de défaillance interne du circuit logique programmable 5.

Sa conception et le fait qu'elle comprenne une possibilité de test en ligne, rend l'interface de puissance sûre ("fail-safe") quelle que soit la panne simple susceptible d'intervenir et quelles que soient les valeurs du signal d'entrée logique E. Les pannes simples susceptibles d'intervenir peuvent concerner aussi bien le système de commande de l'actionneur, à savoir l'oscillateur 4, le circuit 5, les transformateurs 7, les circuits 6, les transistors, l'alimentation et les fils de connexion, que le système de test, à savoir l'horloge de test 8, le circuit 5 et les opto-coupleurs 9. Dans tous les cas, soit l'actionneur passe dans un état sûr, soit la défaillance est signalée par le signal de diagnostic D.

## Revendications

1. Interface de puissance comportant une entrée, destinée à recevoir des signaux d'entrée (E) logiques binaires continus, des moyens (4) de codage dynamique des signaux continus d'entrée (E), des moyens (5, 7, 6) de commande d'un commutateur de puissance, les moyens de commande étant connectés à une sortie (A) des moyens de codage dynamique, et des moyens (9) de surveillance de l'état du commutateur, interface caractérisée en ce que le commutateur comporte au moins deux transistors de puissance (T1, T2) connectés en série avec un actionneur (2) entre les bornes d'une tension d'alimentation (Va), chaque transistor comportant une électrode de commande connectée à une sortie correspondante des moyens de commande, l'interface comportant des moyens d'autotest de l'interface, connectés aux moyens (9) de surveillance et comportant des moyens de production de signaux de test appliqués par les moyens de commande aux électrodes de commande des transistors (T1, T2), de manière à constituer une interface de puissance de sécurité.

2. Interface selon la revendication 1, caractérisée en ce que les moyens d'autotest comportent des moyens (8) de production de signaux d'horloge (H), connectés à une entrée de test des moyens de commande, et des moyens (9) de détection pour détecter la tension aux bornes de chacun des transistors (T1, T2) et fournir aux moyens de commande des signaux (V1, V2) représentatifs desdites tensions, de manière à permettre un test en ligne des transistors de puissance.

3. Interface selon la revendication 2, caractérisée en ce que le test est un test par impulsions fines, les moyens d'autotest appliquant les signaux de test séquentiellement sur les transistors.

4. Interface selon l'une des revendications 1 et 2, caractérisée en ce que les moyens de détection (9) comportent un opto-coupleur.

5. Interface selon l'une quelconque des revendications 1 à 4, caractérisée en ce que les moyens de commande comportent une sortie de diagnostic produisant un signal (D) oscillant en l'absence de défaillance interne à l'interface et un signal (D) continu en cas de défaillance.

6. Interface selon la revendication 5, caractérisée en ce qu'en cas de défaillance interne à l'interface, les moyens de commande produisent des signaux de blocage des deux transistors de puissance (T1, T2).

7. Interface selon l'une quelconque des revendications 1 à 6, caractérisée en ce que les moyens (4) de codage dynamique comportent un oscillateur (4) fournissant des signaux (A) de fréquence prédéterminée lorsque le signal d'entrée (E) prend une première valeur continue prédéterminée et des signaux (A) continus lorsque le signal d'entrée (E) prend une seconde valeur continue prédéterminée.

8. Interface selon la revendication 7, caractérisée en ce que la seconde valeur prédéterminée du signal d'entrée (E) est associée à un état sûr de l'actionneur (2).

9. Interface selon l'une quelconque des revendications 1 à 8, caractérisée en ce que les moyens de commande comportent un circuit logique programmable (5) fournissant sur deux sorties de commande distinctes, respectivement associées à chacun des transistors (T1, T2), des signaux (B1, B2) oscillants lorsque les signaux (A) de sortie des moyens de codage (4) sont des signaux oscillants.

10. Interface selon la revendication 9, caractérisée en ce que les moyens de commande comportent des moyens de mise en forme (7, 6) connectés entre le circuit logique programmable (5) et les transistors (T1, T2), de manière à appliquer sur les électrodes de commande des transistors un signal de commande de saturation lorsque le signal de sortie associé du circuit logique programmable est un signal oscillant, et un signal de commande de blocage lorsque ledit signal de sortie est un signal continu.

## Patentansprüche

1. Leistungselektronische Schaltung mit einem Eingang zur Aufnahme von kontinuierlichen binären logischen Eingangssignalen (E), Mitteln (4) zur dynamischen Kodierung der kontinuierlichen Eingangssignale (E), an einen Ausgang (A) der Mittel zur dynamischen Kodierung angeschlossenen Steuermitteln (5, 6, 7) zur Ansteuerung eines leistungselektronischen Schalters sowie Mitteln (9) zur Überwachung des Schaltzustands des Schalters, dadurch gekennzeichnet, daß der Schalter mindestens zwei, in Reihe mit einem Stellglied (2) zwischen die Klemmen einer Versorgungsspannung (Va) geschaltete Leistungstransistoren (T1, T2) umfaßt, wobei jeder Transistor eine an einen zugeordneten Ausgang der Steuermittel angeschlossene Steuerelektrode und die Schaltung Mittel zur Selbstprüfung umfaßt, die an die Überwachungsmittel (9) angeschlossen sind und Mittel zur Erzeugung von Prüfsignalen umfassen, mit denen die Steuerelektroden der Transistoren (T1, T2) über die Steuermittel beaufschlagt werden, so daß eine leistungselektronische Sicherheitsschaltung gebildet wird.

2. Schaltung nach Anspruch 1, dadurch gekennzeichnet, daß die Selbstprüfungsmittel an einen Prüfeingang der Steuermittel angeschlossene Mittel (8) zur Erzeugung von Taktsignalen (H) sowie Erfassungsmittel (9) zur Erfassung der Spannung an den Klemmen jedes Transistors (T1, T2) und Beaufschlagung der Steuermittel mit die genannten Spannungen abbildenden Signalen (V1, V2) umfassen, derart daß eine Prüfung der Leistungstransistoren während des Betriebs durchgeführt werden kann.

3. Schaltung nach Anspruch 2, dadurch gekennzeichnet, daß die Prüfung mit kurzen Impulsen durchgeführt wird und die Selbstprüfungsmittel die Transistoren sequentiell mit den Prüfsignalen beaufschlagen.

4. Schaltung nach Anspruch 1 und 2, dadurch gekennzeichnet, daß die Erfassungsmittel (9) einen Optokoppler umfassen.

5. Schaltung nach irgendeinem der Ansprüche 1 bis 4, dadurch gekennzeichnet, daß die Steuermittel einen Diagnoseausgang umfassen, der bei Nichtvorhandensein eines internen Fehlers der Schaltung ein Schwingungssignal (D) und bei Vorhandensein eines Fehlers ein kontinuierliches Signal (D) erzeugt.

6. Schaltung nach Anspruch 5, dadurch gekennzeichnet, daß die Steuermittel bei Auftreten eines internen Fehlers der Schaltung Signale zum Sperren der beiden Leistungstransistoren (T1, T2) erzeugen.

7. Schaltung nach irgendeinem der Ansprüche 1 bis 6, dadurch gekennzeichnet, daß die Mittel (4) zur dynamischen Kodierung einen Oszillator (4) umfassen, der Signale (A) mit einer bestimmten Frequenz ausgibt, wenn das Eingangssignal (E) einen bestimmten ersten kontinuierlichen Wert annimmt, und kontinuierliche Signale (A) ausgibt, wenn das Eingangssignal (E) einen bestimmten zweiten kontinuierlichen Wert annimmt.

8. Schaltung nach Anspruch 7, dadurch gekennzeichnet, daß der bestimmte zweite Wert des Eingangssignals (E) einem sicheren Betriebszustand des Stellglieds (2) entspricht.

9. Schaltung nach irgendeinem der Ansprüche 1 bis 8, dadurch gekennzeichnet, daß die Steuermittel einen programmierbaren Logikschaltkreis (5) umfassen, der an zwei unterschiedlichen, jeweils einem der Transistoren (T1, T2) zugeordneten Steuerausgängen Schwingungssignale (B1, B2) ausgibt, wenn die Ausgangssignale (A) der Kodierungsmittel (4) Schwingungssignale darstellen.

10. Schaltung nach Anspruch 9, dadurch gekennzeichnet, daß die Steuermittel zwischen den Logikschaltkreis (5) und die Transistoren (T1, T2) angeschlossene Formungsmittel (7, 6) umfassen, so daß die Steuerelektroden der Transistoren mit einem Durchschalt-Steuersignal beaufschlagt werden, wenn das zugeordnete Ausgangssignal des programmierbaren Logikschaltkreises ein Schwingungssignal darstellt, und mit einem ein Sperr-Steuersignal beaufschlagt werden, wenn das genannte Ausgangssignal ein kontinuierliches Signal darstellt.

## Claims

1. A fail-safe power interface comprising an input designed to receive continuous binary logic input signals (E), means (4) for dynamic encoding of the continuous input signals (E), means (5, 7, 6) for controlling a power switch, the means for controlling being connected to an output (A) of the means for dynamic encoding, and means (9) for monitoring the state of the switch, an interface characterized in that the switch comprises at least two power transistors (T1, T2) connected in series with an actuator (2) between the terminals of a supply voltage (Va), each transistor comprising a control electrode connected to a corresponding output of the control means, the interface comprising means for self-testing of the interface, connected to the means (9) for monitoring and comprising means for producing test signals applied by the control means to the control electrodes of the transistors (T1, T2), so as to constitute a fail-safe power interface.

2. The interface according to claim 1, characterized in that the self-testing means comprise means (8) for producing clock signals (H), connected to a test input of the controlling means, and detection means (9) to detect the voltage at the terminals of each of the transistors (T1, T2) and to supply to the controlling means signals (V1, V2) representative of said voltages, so as to enable on-line testing of the power transistors.

3. The interface according to claim 2, characterized in that the test is a test by finite pulses, the self-testing means applying the test signal sequentially to the transistors.

4. The interface according to one of the claims 1 and 2, characterized in that the detection means (9) comprise an opto-coupler.

5. The interface according to any one of the claims 1 to 4, characterized in that the controlling means comprise a diagnostics output producing an oscillating signal (D) in the absence of a failure internal to the interface and a continuous signal (D) in case of a failure.

6. The interface according to claim 5, characterized in that in the event of a failure intemal to the interface, the controlling means produce turn-off signals of the two power transistors (T1, T2).

7. The interface according to any one of the claims 1 to 6, characterized in that the means (4) for dynamic encoding comprise an oscillator (4) supplying signals (A) of preset frequency when the input signal (E) takes a first preset continuous value and continuous signals (A) when the input signal (E) takes a second preset continuous value.

8. The interface according to claim 7, characterized in that the second preset value of the input signal (E) is associated to a safe state of the actuator (2).

9. The interface according to any one of the claims 1 to 8, characterized in that the controlling means comprise a programmable logic circuit (5) supplying on two distinct control outputs, respectively associated to each of the transistors (T1, T2), oscillating signals (B1, B2) when the output signals (A) of the encoding means (4) are oscillating signals.

10. The interface according to claim 9, characterized in that the controlling means comprise shaping means (7, 6) connected between the programmable logic circuit (5) and the transistors (T1, T2), so as to apply a turn-on control signal to the control electrodes of the transistors when the associated output signal of the programmable logic circuit is an oscillating signal, and a turn-off control signal when said output signal is a continuous signal.
